# EUROPEAN PATENT APPLICATION

(11) **EP 2 458 639 A1**
(43) Date of publication of application: **30.05.2012**
(21) Application number: 10192618.6
(22) Date of filing: 25.11.2010
(51) Int. Cl.: H01L 29/732, H01L 29/06, H01L 29/10, H01L 21/331

(54) **Bipolar transistor with base trench contacts insulated from the emitter.**

(71) Applicant: NXP B.V., 5656 AG Eindhoven (NL)
(72) Inventor: Boettcher, Tim, Redhill, Surrey RH1 1DL (GB); Jahmann, Fabian, Redhill, Surrey RH1 1DL (GB); Holland, Steffen, Redhill, Surrey RH1 1DL (GB); Habenicht, Soenke, Redhill, Surrey RH1 1DL (GB)
(74) Representative: Hardingham, Christopher Mark

(57) **Abstract**

Trench-based contacts are used for a bipolar transistor to contact the base active area and to lower the base-emitter surface junction area. This leads to a decrease in the transistor's switching times and at the same time to an increase of the base-emitter breakdown voltage. By using this contact technique, the base contact area can be substantially decreased, which leads to an increase of the emitter area, with positive effect on the saturation resistance of the device.

## Description

The invention relates to a bipolar transistor with base contacts and to methods of making the bipolar transistor.

Bipolar transistors may be used in a wide variety of applications, either in discrete devices or as a part of integrated circuits on a semiconductor chip. Power bipolar transistors are prominent for switching high current densities and high absolute currents on a semiconductor chip, by applying a low steering current on the steering connection, the so-called base - which controls a significant higher current between the main ports of the transistor - so-called emitter and collector.

Of great importance in this context is the minimization of the electric resistance of the device in saturated on-state mode - the so-called saturation resistance - because this resistance is most relevant for the electric losses during the switching period. A second point of importance is the minimization of the switching times, in particular the rise and fall times of the transistor during on- and off-switch mode. The power dissipation during switching limits the maximum current to be applied through the transistor and therefore the possible fields of applications for the device.

The minimization of the saturation resistance of bipolar transistors has been a field of technical progress for many years. The most prominent contributors to the saturation resistance are the doping concentrations and depths of base and emitter in the active area, the thickness of the epitaxial layer which defines the breakdown voltage and the Ohmic contributions of emitter, base and collector.

On top of that bipolar transistors are increasingly being used at higher switching frequencies and the minimization of switching losses in such devices is important. The switching time is an important parameter to control in such devices, since to minimise the switching losses a decrease of raise and fall time of the transistor is needed.

A minimization of the storage time can be achieved by protecting the transistor from over-saturation with charge carriers during the on-state of the transistor, i.e. the state in which the transistor carries current. Mechanisms for achieving this include parasitic diodes and transistors, which prevent an over-saturation of base and collector. These measures have the effect of enhancing the saturation resistance because the effective base current decreases significantly. Therefore saturation resistance and switching times cannot be optimized in this architecture simultaneously.

Accordingly, the construction of a device having reduced switching time needs to be adjusted to the needs of saturation resistance and switching times with respect to the specific field of application.

Another method to reduce switching times is the addition of recombination centers, which decrease the carrier life time in base and collector. In most cases, this is realized by so-called "killing"-processes using e.g. Au or Pt dopants. This measure prevents over-saturation, but it causes a significant increase of the saturation resistance as before. On top of that, killing processes result in a decrease of the current gain and in a significant increase of the leakage current behavior of the device.

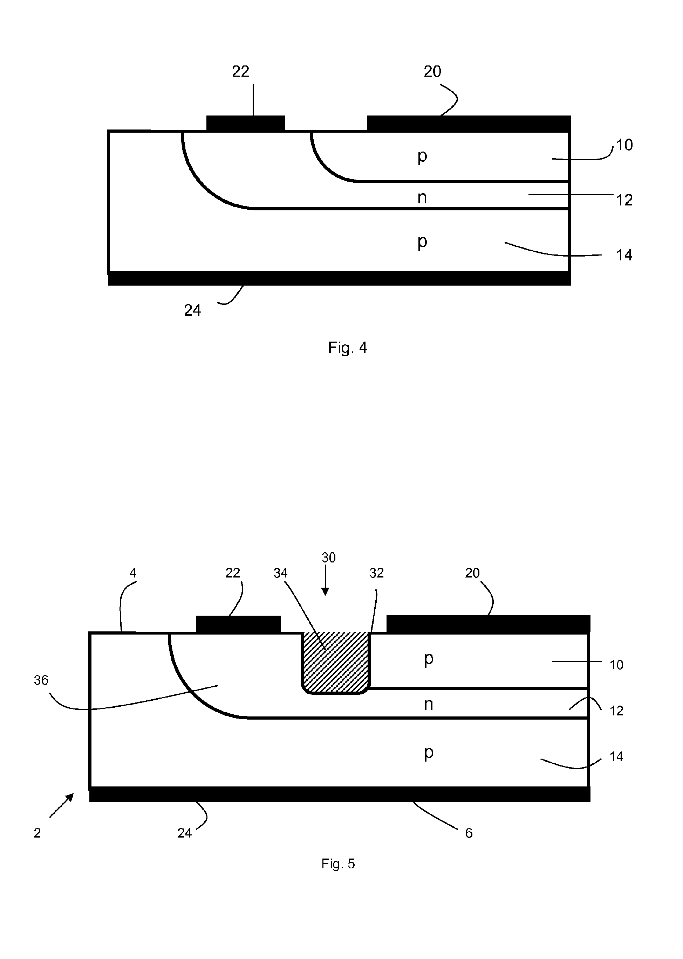

In order to illustrate the current state of the art, Figure 4 schematically illustrates the layer structure of a transistor built in a planar bipolar technology. A emitter 10, base 12 and collector 14 are connected with front side emitter 20 and base 22 contacts and a rear collector contact 24.

The base and emitter may be distributed across the device in form of a stripe- or net-like structure. A large emitter area with a homogeneous contact through the base diffusion is crucial to achieve a high current density per available chip area. This means that emitter area and base-emitter contact area are the parameters, which define the specification of a modern high-performance bipolar transistor.

The front side contact of the active base and emitter diffusions is achieved through one patterned layer with the contact metal preferentially based on Al, Al/Si or Al/Si/Cu. The emitter contact area has to be maximized to reduce the saturation resistance, since a large contact area minimizes the voltage drop in the emitter diffusion region. However, the emitter area available for metallization is limited in a single-layer metal contact due to the required contact structures from base bond pad to the base diffusions. Those structures are commonly separated from the active layer by an oxide layer and lead on top of the emitter area from bond pad to base contact, thereby directly reducing the available area for emitter contact.

In a two-layer metal structure (not shown) it is possible to optimize the emitter contact structure in such a way that the base connections are placed in the second metal layer on top of the emitter contact layer. In this case the full emitter area in between the base contacts is available for contact and the emitter resistance drops accordingly. The contact layer can be protected from mechanical and electrochemical damage using an additional passivation layer. Commonly this passivation layer is formed by silicon oxide or silicon nitride.

However, there remains a need for improvements in the field of bipolar transistors.

According to the invention there is provided a bipolar transistor according to claim 1.

The aim of is to allow simultaneously a minimization of saturation voltage and switching times, especially rise and fall times.

This is achieved by using a structure with inherently reduced effective base volume. With this approach the amount of minority carriers below the base contacts can be minimized, which remain in the base and collector during the storage time. The presence of the minority carriers has a strong influence on the formation and reduction of the junction capacitances and leads to increased rise and fall times.

The product architecture should be able to combine different methods of switching time reduction. Trenches can help to avoid an over-saturation of minority carriers in regions where the steady state device performance is not degraded. In addition they may completely suppress curvature effects at the edge of doping regions. Trenches are produced by etching into the semiconductor. Commonly, the trench sidewalls are covered with an isolating material and finally filled with an electrically conducting material, e.g. such as doped polysilicon or metal. With this way it is possible to insert electrically conducting regions into the semiconductor material.

Embodiments of the invention will now be described, purely by way of example, with reference to the accompanying drawings, in which:
Figure 1 shows a first embodiment of the invention;
Figure 2 shows results from the first embodiment of the invention and a comparative example;
Figure 3 shows results from the first embodiment of the invention and the comparative example;
Figure 4 illustrates the comparative example used for comparison in Figures 2 and 3;
Figure 5 illustrates a second embodiment of the invention;
Figure 6 illustrates a first arrangement of elements across the first major surface according to an implementation of an embodiment of the invention;
Figure 7 illustrates a second arrangement of elements across the first major surface according to an implementation of an embodiment of the invention;
Figure 8 illustrates a third arrangement of elements across the first major surface according to an implementation of an embodiment of the invention;
Figure 9 illustrates a fourth arrangement of elements across the first major surface according to an implementation of an embodiment of the invention;
Figure 10 illustrates a fifth arrangement of elements across the first major surface according to an implementation of the invention;
Figure 11 illustrates a sixth arrangement of elements across the first major surface according to an implementation of an embodiment of the invention;
Figure 12 illustrates a third embodiment of the invention.

The same reference numbers are used for like or corresponding features in different Figures and the description relating thereto is not necessarily repeated. The Figures are schematic and not to scale.

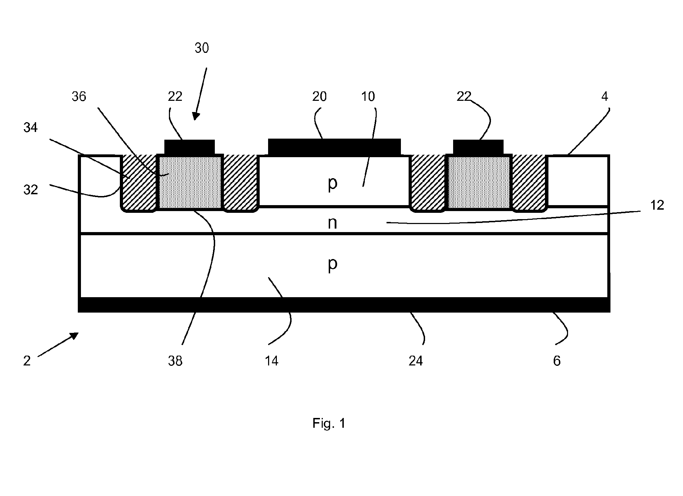

An embodiment of the invention is shown in Figure 1.

A semiconductor body 2 is shown with a first major surface 4 and an opposed second major surface 6. The body includes a p-type emitter region 10 at the first major surface 4, a p-type collector region 14 at the second major surface, and an n-type base region 12 between the emitter region 10 and the collector region 14 making up a bipolar transistor. Without any effect to the functionality of the device, the polarities of the mentioned regions can be interchanged, i.e. n-type regions substituted for p-type regions.

The emitter region 10 is contacted by emitter contact 20 on the emitter region at the first major surface and the collector region 14 is contacted by a collector contact 20 on the second major surface.

To connect to the base, a trench structure generally indicated as 30 is formed. The trench has sidewalls 32 which are covered in an isolation layer forming isolation region 34. The trench extends vertically from the first major surface to the base region 12 and is filled with a conductive material 36, in the example polysilicon. The bottom 38 of the trench is not insulated so that the conductive material 36 contacts the base region. A base contact 22 is provided at the first major surface on the conductive material which connects to the base region 12 through the conductive material.

Thus, the connection of the base region 12 at the first major surface 4 is realized by a trench structure 30 through the emitter. A pattern of trenches making up the structure 30, as discussed below, is arranged in the emitter region 10 for a homogeneous connection of the base region 12. The side walls of the trenches are covered with the isolation region 34, which is preferably silicon oxide, in order to prevent shorts of the trench contacts with the emitter. The bottom 38 of the trench is not covered by the isolation layer, which allows the creation of an electrical connection to the base by filling the trench with a conducting material, e.g. polysilicon or metal. For polysilicon, the conduction is realized by doping - preferably phosphorous or boron, but other dopants are also possible.

The embodiment has two major aspects:
Firstly by contacting the base region 12 via the trench structure 30, a base-emitter junction is only realized in vertical projection of the device. Because of the isolation layer on the sidewalls of the trenches, there is no contact between emitter and base at the first major surface 4. On top of that, no curved edge area exists between emitter and base, as is inevitable in a classic architecture. Because of the missing edge curvature the electric field is homogenized in base and emitter, and therefore significantly decreased in the edge area. This leads to a significantly increased base-emitter breakdown voltage and collector-emitter reverse blocking voltage.

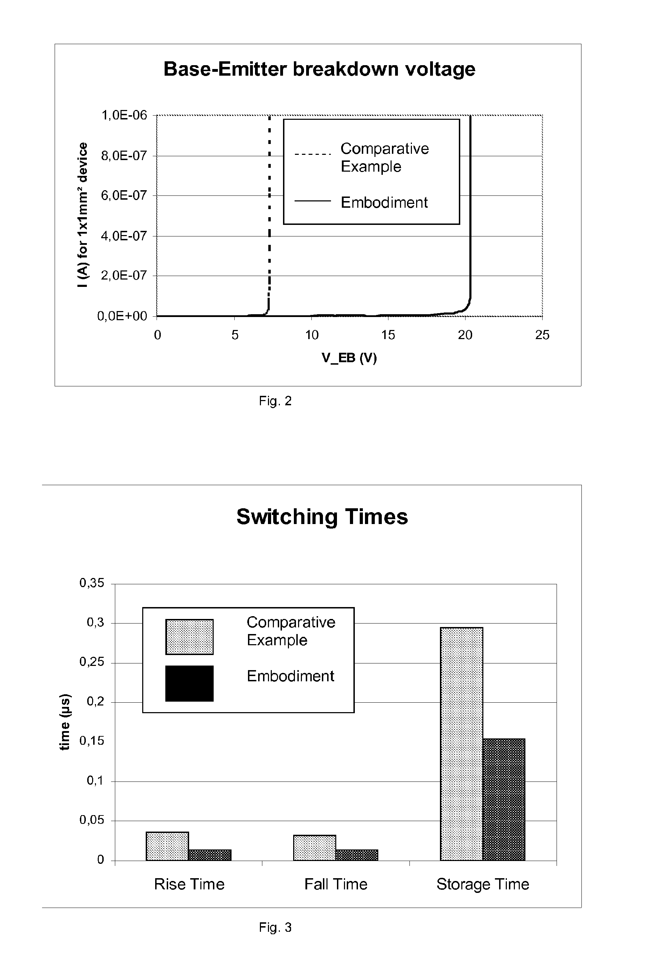

This breakdown voltage improvement is shown in Figure 2, which shows in a dotted line a transistor without the trenches and with a solid line a transistor with the trenches as in this embodiment. The comparative example of a transistor without trenches is implemented as shown in Figure 4. This breakdown voltage is a unique feature of a bipolar transistor with respect to a MOSFET. In the architecture of Figure 4, such a significant increase in the base-emitter breakdown voltage can only be reached by a significant decrease of the base doping concentration, with severe impact on other important parameters such as the collector-emitter breakdown voltage or the current capability.

Secondly, by filling the trench structures 30 with conducting material the effective volume of the base is reduced significantly. Only that part of base region 22 directly under the emitter region 20 functions as a base. Therefore, the total amount of charge needed for switching the transistor is also reduced which results in a significant decrease of the switching time. On top of that, the diffusion carrier concentration below the base contacts in the collector area is decreased because of the smaller size of the base contacts. Therefore, deep storage is prevented, which is one of the major reasons for enlarged rise and fall times of a bipolar transistor, especially for the larger switching times in relation to MOSFETs.

This effect of deep storage can be reduced significantly, and allows for specifying switching times which were formerly only reachable with process methods like killingprocesses, with severe impact on other transistor parameters. Figure 4 shows the improvement in switching time between the same comparative example and the transistor according to the embodiment.

In an alternative embodiment, as shown in Figure 5, a bipolar transistor is shown with a trench structure 30 in the base-emitter contact area, which separates the sidewalls of the emitter region 20 from the base region 22. The trench is filled with an isolation material 34, preferably silicon-oxide. Note that in this case the base contact 22 directly contacts the base region 12 - effectively the conductive region 36 which is metallic in the embodiment of Figure 1 is in this arrangement part of the semiconductor base region 12.

This leads to an enhanced base-emitter breakdown voltage and collector-emitter reverse blocking voltage, because the spreading of the depletion layer is arranged preferably in vertical direction. By this, the lateral 1-D breakdown ratio base-emitter is significantly reduced and allows the realization of enhanced breakdown voltages with a minimum of process arrangements, because the trenches do not have to be filled with conducting material. This eases the process and design integration into classical bipolar process flows and design concepts and allows a cheap production.

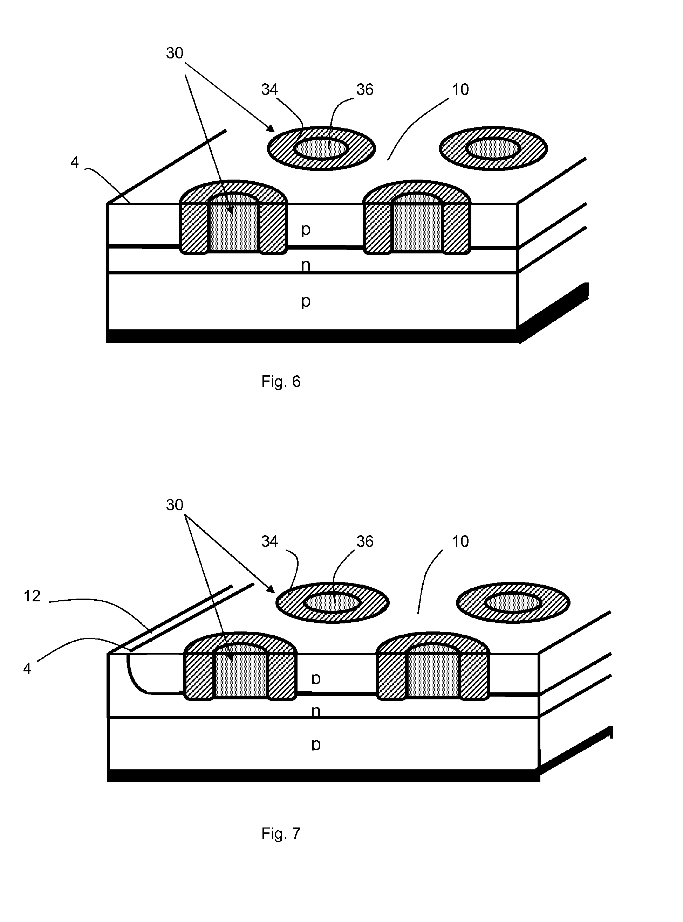

Different patterns of trench structures across the first major surface may be provided. Figures 6 to 9 show bipolar transistors with various mesh-like patterns of base connections via trench structures 30. The contacts 20,22 are omitted for clarity. The trench contacts may have different shapes and sizes (from below 0.1 µm up to several tens of µm) and may be arranged in different geometrical patterns (hexagonal, cubic etc.).

Figure 6 shows a pattern corresponding to the embodiment of Figure 1. In this case, the trench structure 30 is cylindrical and a number of such cylinders are provided across the surface to provide a connection to the base region 12 across the surface. Conductive regions 36 to which the base contacts 22 (not shown) are connected are each surrounded by an isolation region 34 which in turn is surrounded by the emitter region 10. In this embodiment, the trench structures 30 result in base contacts only- in this case the edge termination is formed by a MESA-structure.

It is also possible that the edges of the emitter region are not formed by trench structures. Figure 7 shows an example where the emitter region 10 does not extend to the edge of the mesa and the base region 12 is exposed on the surface in the base region. Although this embodiment does have a base-emitter junction in the edge region, this does not contribute significantly to the switching performance, especially as the base region 12 is not connected to the base contact in the edge region.

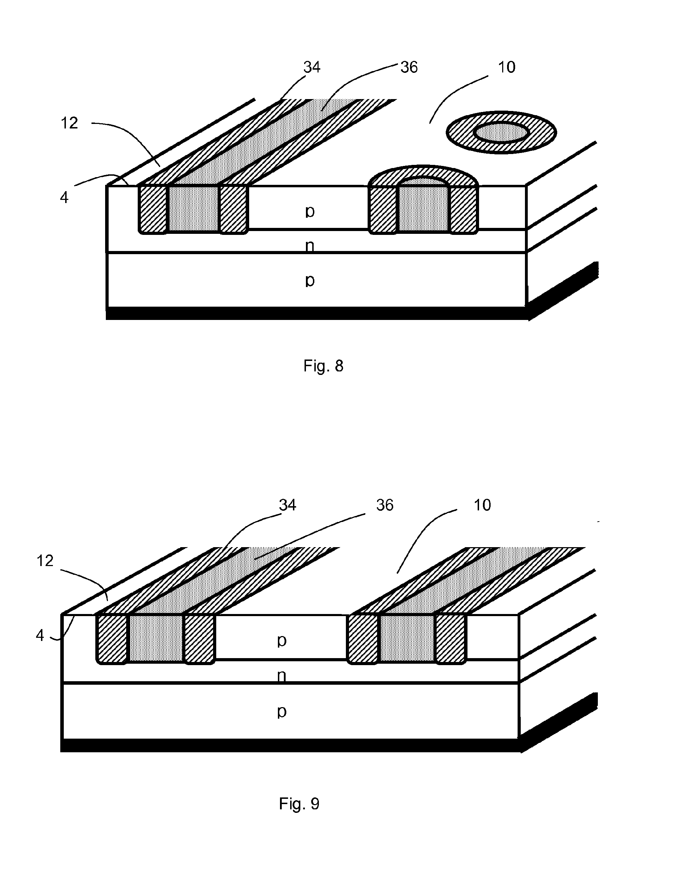

A linear conductive trench structure 30 may be used to define the edge of the mesa as shown in Figure 8.

Figure 9 illustrates a case where linear conductive trench structures 30 extend across the first major surface in one direction instead of the cylindrical structures of Figure 6.

Other patterns are also possible - all that is required is emitter regions 20 and conductive regions 36 of the trench structures are arranged across the surface with isolation material 36 between them. These patterns may also be implemented using the approach of Figure 5 in which contact is made directly to semiconductor base region 12 instead of Figure 1 using metallic conductor 36.

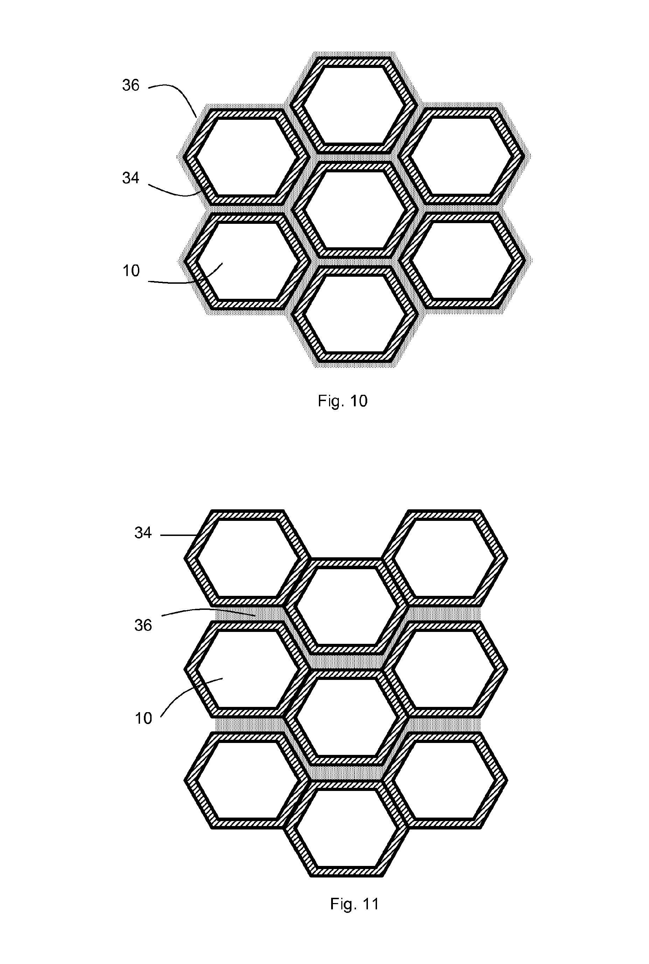

It is not necessary that the patterns are circular, or that the emitter regions 10 are outside the conductive regions 36. For example, Figure 10 illustrates the use of hexagonal patterns in an arrangement with the emitter regions 10 forming the bulk of the first major surface with hexagonal conductive regions 36 separated by insulation regions 34.

Figure 11 shows a variation of the arrangement of Figure 10 in which conductive regions 36 are not provided between every adjacent pair of emitter regions 10.

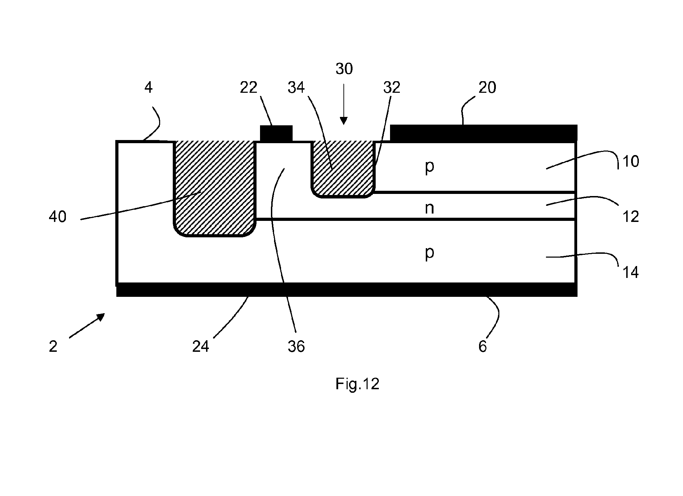

Figure 12 illustrates a further embodiment, in which a similar approach is used for the base-collector junction. In this case, a second trench structure 40 is provided filled with second isolation material 42. Conveniently, the same material is used for the second isolation material 42 as the isolation material 34.

The embodiments described allow for a number of advantages.

As already indicated, the arrangements described may allow for a reduction of the raise and fall times of a bipolar transistor due to the formation of the base contact using a trench-based structure. This lowers the saturation charge in the volumes underneath the base contacts and reduces the deep storage effect, such that faster switching of the transistor is achieved with the related reduction of switching power losses.

Note that such reduction in the rise and fall times may be achieved without needing to use so-called "killing" processes (like Au or Pt diffusion into the active area of the silicon). These have negative influence the saturation voltage, leakage current and lifetime stability due to the formation of deep traps for charge carriers in the active area. Nevertheless, if required, such processes may be used in addition.

Embodiments may deliver a reduction of the switching times in combination with a reduction of the saturation voltage, which is achieved through the improved contact of the base-emitter edge area.

The trench structures 30 used may be very narrow at the base contacts, which in turn increases the emitter area, improves the saturation voltage and raises the maximum operation current. The width of base trench contacts can be reduced down to 0.1 µm width, which is more than one magnitude smaller than the conventional width of a base contact.

Embodiments can lower the extrinsic base resistance, since the base contact is replaced by a low-resistivity trench contact. This reduces the transistor noise level due to the minimization of the thermal noise arising from the extrinsic base resistance.

A bipolar transistor according to some embodiments can deliver a high base-emitter breakdown voltage, since the premature, lateral breakdown at the base-emitter contact curvature is suppressed. Note, that this increase in base-emitter breakdown voltage can be achieved without a reduction of the base or emitter doping level, which would be detrimental for the saturation voltage and the current amplification.

An additional trench structure may be provided at the base-collector contact area. This allows for an increased base-collector breakdown voltage in the same process and design architecture as used for the aforementioned optimization steps.

The collector contact (24) may be formed on the first major surface instead of the second major surface. This is particularly convenient in cases for which the collector region (14) is exposed at the first major surface (4)

## Claims

1. A bipolar transistor, comprising
a semiconductor body (2) having a first major surface (4) and an opposed and second major surface (6),
an emitter region (10) of first conductivity type at the first major surface (4);
a collector region (14) of first conductivity type spaced from the emitter towards the second major surface (6);
a base region (12) of second conductivity type opposite to the first conductivity type between the collector region (14) and the emitter region (10);
an emitter contact (20) connecting to the emitter region;
a base contact (22) connecting through a conductive region (36) to the base region (12); and
a collector contact (24) connected to the collector;
wherein an isolation region (34) extends in a trench structure (30) from the first major surface directly between the emitter region (10) and the conductive region (36) to separate the base and emitter at the first major surface.

2. A bipolar transistor according to claim 1 wherein the trench structure (30) includes a trench with insulating material on the sidewalls (32) of the trench but not the bottom of the trench (38) to form the isolation region (34) and wherein the conductive material fills the trench and is in contact with the base region (12) through the bottom (38) of the trench.

3. A bipolar transistor according to any preceding claim wherein the conductive region (36) is a metallic conductive material.

4. A bipolar transistor according to any preceding claim wherein the conductive region (36) is conductive polysilicon.

5. A bipolar transistor according to claim 1 wherein the trench structure (30) is a trench filled with the material of the isolation region (34) and wherein the conductive region (36) is semiconductor of the second conductivity type in contact with or forming part of the base region (12).

6. A bipolar transistor according to any preceding claim wherein the emitter region (10) surrounds the isolation region (34) and the isolation region (34) surrounds the conductive region (36).

7. A bipolar transistor according to any of claims 1 to 5 wherein the isolation region (34) surrounds the emitter region (10) and the conductive region (36) surrounds the isolation region (34).

8. A bipolar transistor according to any of claims 1 to 5 wherein the emitter region (10) partly surrounds the isolation region (34) and the isolation region (34) partly surrounds the conductive region (36).

9. A bipolar transistor according to any of claims 1 to 5 wherein the isolation region (34) partly surrounds the emitter region (10) and the conductive region (36) partly surrounds the isolation region (34).

10. A bipolar transistor according to any of claims 1 to 5 wherein the emitter region (10), the isolation region (34) and the conductive region (36) are arranged as adjacent stripes extending in a longitudinal direction across the first major surface of the semiconductor body.

11. A bipolar transistor according to any preceding claim wherein the collector is exposed on the first major surface.

12. A bipolar transistor according to any preceding claim wherein the lateral size of the conductive region (36) is at most 1 µm, preferably at most 0.3 µm.

13. A bipolar transistor according to any preceding claim wherein the lateral size of the base contact (22) is at most 1 µm, preferably at most 0.3 µm.

14. A bipolar transistor according to any preceding claim wherein the collector contact (24) is on the second major surface (6).

15. A bipolar transistor according to any preceding claim wherein the collector contact (24) is on the first major surface (4).
